# EUROPÄISCHE PATENTSCHRIFT

(11) **EP 1 540 785 B1**
(45) Veröffentlichungstag und Bekanntmachung des Hinweises auf die Patenterteilung: **03.12.2008**
(21) Anmeldenummer: 03790837.3
(22) Anmeldetag: 30.07.2003
(51) Int. Cl.: H01S 5/14

(54) **HALBLEITERLASERVORRICHTUNG**
SEMICONDUCTOR LASER DEVICE
DISPOSITIF LASER A SEMICONDUCTEURS

(30) Priorität: 02.09.2002 DE 10240949; 25.10.2002 DE 10250046
(43) Veröffentlichungstag der Anmeldung: 15.06.2005
(73) Patentinhaber: LIMO Patentverwaltung GmbH & Co. KG, 36419 Gerstengrund (DE)
(72) Erfinder: MIKHAILOV, Aleksei, 44227 Dortmund (DE); HILL, Wieland, 44388 Dortmund (DE)
(74) Vertreter: Basfeld, Rainer
(86) Internationale Anmeldenummer: PCT/EP2003/008410
(87) Internationale Veröffentlichungsnummer: WO 2004/021524

(56) Entgegenhaltungen:
- WO-A-98/15994
- WO-A-02/082593
- US-A- 4 797 894
- US-A- 5 050 179
- US-A- 5 773 345
- US-B1- 6 212 216

## Beschreibung

Die vorliegende Erfindung betrifft eine Halbleiterlaservorrichtung gemäß dem Oberbegriff des Anspruchs 1.

Eine Halbleiterlaservorrichtung der vorgenannten Art ist aus der US-A-5 050 179 bekannt. Eine der darin beschriebenen Halbleiterlaservorrichtungen umfasst eine konkave reflektierende Fläche, die zylindrisch ausgebildet ist und eine Brennweite aufweist, die dem Abstand der reflektierenden Fläche von der Austrittsfläche des Halbleiterlaserelements entspricht. Etwa auf halbem Weg zwischen der Austrittsfläche und der reflektierenden Fläche ist ein Linsenmittel angeordnet, das zur Kollimation der Fast-Axis-Divergenz des Laserlichts dient. Zwischen Linsenmittel und reflektierender Fläche, benachbart zu dieser ist eine Aperturblende angeordnet, die zur Detektion einzelner Moden des Laserlichts beitragen soll.

Eine Halbleiterlaservorrichtung gemäß dem Oberbegriff von Anspruch 1 ist aus der JP-A-2001 332810 bekannt.

Eine weitere Halbleiterlaservorrichtung ist aus OPTICS LETTERS, 2002, Vol. 27, No. 3, Seite 167 bis 169 bekannt. Bei der darin beschriebenen Halbleiterlaservorrichtung wird als Halbleiterlaserelement eine Laserdiode verwendet, die als sogenannter Breitstreifenemitter ausgebildet ist. Bei derartigen Breitstreifenemittern sind beispielsweise Austrittsflächen für das Laserlicht vorgesehen, die eine Breite von etwa 100 µm und eine Höhe von etwa 1 µm aufweisen. Über diese Breite können sich innerhalb des internen, durch die Endflächen der Laserdiode gebildeten Resonators eine ganze Reihe von unterschiedlichen transversalen Moden des Laserlichtes ausbilden. Gleichzeitig können auch eine ganze Reihe von longitudinalen Moden, d. h. unterschiedlichen Wellenlängen des Laserlichtes auftreten. Insbesondere die vielen unterschiedlichen transversalen Moden beeinträchtigen die Strahlqualität des aus einem derartigen Breitstreifenemitters austretenden Laserstrahls. Eine derartige Laserstrahlung ist nicht optimal fokussierbar. Die longitudinalen Moden führen zu einer für verschiedene Anwendungen unerwünschten spektralen Verbreiterung.

In der vorgenannten Veröffentlichung wird daher ein externer Resonator vorgeschlagen, der einen hochreflektierenden planen Spiegel umfasst. Zwischen dem Planspiegel und der dem externen Resonator zugewandten Austrittsfläche des Halbleiterlaserelementes sind zum einen eine Fast-Axis-Kollimationslinse und zum anderen zwischen der Fast-Axis-Kollimationslinse und dem Planspiegel eine sphärische Konvexlinse angeordnet. Die Fast-Axis-Kollimationslinse dient dazu, das in der ersten Richtung wesentlich stärker divergente Licht des Breitstreifenemitters zu kollimieren. Die sphärische Konvexlinse dient dazu, das von dem Planspiegel zurückreflektierte Licht derart zu fokussieren, dass es im wesentlichen auf die Austrittsfläche zurück abgebildet wird. Weiterhin ist in dem externen Resonator eine Aperturblende vorgesehen. Sowohl die Aperturblende als auch der plane Spiegel sind außerhalb der optische Achse des externen Resonators bzw. außerhalb der Normalen oder Mittelsenkrechten auf der Austrittsfläche angeordnet. Es zeigt sich, dass bei Breitstreifenemittern die stärkeren Moden in der Regel unter einem kleinen Winkel zur Normalen auf der Austrittsfläche aus dieser austreten. Durch die außerhalb der Achse positionierte Aperturblende werden somit nur Anteile einer derartigen unter einem Winkel aus der Austrittsfläche austretenden Mode auf den Spiegel fallen und von ihm durch die Aperturblende und die sphärische Linse zurück auf die Austrittsfläche reflektiert werden. Nur Licht aus einer oder mehrerer derartiger Moden wird somit durch die Austrittsfläche in die Laserdiode zurückreflektiert. Auf diese Weise kann erreicht werden, dass die Laserdiode im wesentlichen auf dieser Mode anschwingt, so dass das Modenspektrum des Halbleiterlaserelementes im wesentlichen auf eine transversale Mode reduziert wird.

Aus dem externen Resonator gemäß dem vorgenannten Stand der Technik wird das Laserlicht dadurch ausgekoppelt, dass die unter entgegengesetzt gleichem Winkel aus der Austrittsfläche austretenden Teilstrahlen der entsprechenden bevorzugten transversalen Mode an der Aperturblende und dem Planspiegel vorbei aus der Halbleiterlaservorrichtung austreten können.

Als nachteilig bei der vorgenannten Anordnung erweist sich, dass eine vergleichsweise große Anzahl von unterschiedlichen optischen Elementen in dem externen Resonator vorgesehen sind. Dies sind neben der Fast-Axis-Kollimationslinse die sphärische Linse, die Aperturblende und der plane Endspiegel. Durch die vielen verschiedenen in dem externen Resonator vorgesehenen optischen Elemente treten zum einen vermehrt Abbildungsfehler auf und entstehen zum anderen große Verluste, da sich diese Elemente innerhalb des Laserresonators befinden. Dadurch wird aber die erreichbare Ausgangsleistung einer derartigen Halbleiterlaservorrichtung stark begrenzt. Gleichzeitig können die mit einer derartigen Halbleiterlaservorrichtung erreichbaren Ausgangsleistungen nur mit einem hohen Kostenaufwand erzielt werden. Zusätzlich ist eine derartige Halbleiterlaservorrichtung nur schwer zu justieren.

Gemäß dem Stand der Technik wird weiterhin versucht, das Modenspektrum von Halbleiterlaserelementen durch Strukturierung der aktiven Zone des Halbleiterlaserelements zu beeinflussen. Diese Strukturierungen können beispielsweise Veränderungen des Brechungsindex in verschiedenen Richtungen umfassen, so dass durch diese sich in verschiedenen Richtungen ändernden Brechungsindizes die Ausbreitung einzelner bevorzugter transversaler Lasermoden bevorzugt wird. Weiterhin besteht die Möglichkeit, beispielsweise durch unterschiedliche Dotierungsgrade auf die Anzahl der zur Rekombination zur Verfügung stehenden Elektronen-Loch-Paare einzuwirken, so dass an unterschiedlichen Stellen der aktiven Zone unterschiedliche Verstärkungen des Laserlichtes möglich sind. Beide vorgenannten Methoden zur Bevorzugung einzelner transversaler Moden sind mit beträchtlichem Fertigungsaufwand verbunden und ergeben ebenfalls keine wirklich befriedigende Strahlqualität bzw. Ausgangsleistung der Halbleiterlaservorrichtung.

Die Aufgabe der vorliegenden Erfindung ist die Schaffung einer Halbleiterlaservorrichtung der eingangs genannten Art, die mit einfachen Mitteln eine vergleichsweise hohe Strahlqualität und hohe Ausgangsleistung gewährleistet.

Dies wird erfindungsgemäß durch eine Halbleiterlaservorrichtung der eingangs genannten Art mit den kennzeichnenden Merkmalen des Anspruchs 1 erreicht. Die Unteransprüche betreffen bevorzugte Ausgestaltungen der Erfindung.

Die reflektierende Fläche kann beispielsweise sphärisch gekrümmt sein. Dabei kann das Linsenmittel, dass im wesentlichen als Fast-Axis-Kollimationslinse dienen kann, derart ausgebildet sein, dass die Divergenz des aus der Austrittsfläche austretenden und durch das Linsenmittel hindurch tretenden Lichts sowohl in der ersten Richtung als auch in der dazu senkrechten zweiten Richtung für einzelne transversale Moden im wesentlichen gleich ist. Die reflektierende Fläche weist in der ersten Richtung und in der dazu senkrechten zweiten Richtung eine im wesentlichen gleich große Krümmung auf.

Gemäß einer bevorzugten Ausführungsform der vorliegenden Erfindung ist der optische Abstand zwischen der reflektierenden Fläche und der Austrittsfläche des Halbleiterlaserelements im wesentlichen gleich der Brennweite der reflektierenden Fläche hinsichtlich mindestens einer der Richtungen. Auf diese Weise wird eine konfokale Anordnung der reflektierenden Fläche hinsichtlich der Austrittsfläche erreicht. Hierbei kann der Durchmesser der zu einzelnen transversalen Moden gehörenden Teilstrahlen in der Ebene der Austrittsfläche ein Minimum (Strahltaille) aufweisen, wodurch die Auswahl bestimmter Moden begünstigt werden kann.

Es besteht die Möglichkeit, dass die Brennweite des Linsenmittels sehr klein ist, beispielsweise etwa 1 mm beträgt.

Vorteilhafterweise weist die dem Reflexionsmittel zugewandte Austrittsfläche des Halbleiterlaserelementes eine Breite von mehr als 500 µm, insbesondere mehr als 1 mm auf. Derartige sehr breite Emitter erzeugen zum einen sehr hohe Leistungen, wobei zum anderen die Divergenz in der Slow-Axis-Richtung, das heißt in der Richtung, in der sich die Emitter über beispielsweise 1 mm erstrecken, sehr klein, insbesondere beinahe beugungsbegrenzt klein

Vorteilhafterweise könnte dabei die reflektierende Fläche als wellenlängenselektives Element, insbesondere als Gitter ausgebildet sein.

Letztlich werden Topologie, Ausrichtung und Abstand der reflektierenden Fläche derart gewählt, dass ein Fourier-Bild der Abstrahlung der Austrittsfläche in der Ebene der Austrittsfläche selbst erzeugt wird.

Es besteht aber auch die Möglichkeit, sich entlang der Normalen ausbreitende Moden mit einer reflektierenden Fläche zu selektieren, die senkrecht zur Normalen ausgerichtet ist. Durch entsprechende Wahl der Position der reflektierenden Fläche kann somit eine gewünschte transversale Mode ausgewählt werden, die dann bevorzugt in das Halbleiterlaserelement zurück reflektiert wird. Auf diese Weise wird mit einfachen Mitteln erreicht, dass die Halbleiterlaservorrichtung Laserlicht abgibt, das im wesentlichen nur eine transversale Mode oder wenige transversale Moden aufweist.

Bei dieser Ausführungsform erweist es sich als besonders vorteilhaft, wenn die Strahltaille ähnlich groß ist wie die Austrittsfläche, weil dann zum einen geringe Verluste auftreten und zum anderen eine hohe Rückkopplung über die gesamte Breite des Emitters beziehungsweise die gesamte Breite der Austrittsfläche ermöglicht wird. Die hohe Rückkopplung über die gesamte Breite der Austrittsfläche und damit über die gesamte Breite der Laserdiode ist für eine gleichmäßige Anregung der bevorzugten Mode in einem möglichst großen Teil des zur Laseremission beitragenden Volumens der Laserdiode bedeutsam.

Aufgrund der Tatsache, dass in der Regel die Ausdehnung der Austrittsfläche in der Slow-Axis wesentlich größer ist als in der Fast-Axis, erweist sich die erfindungsgemäße Ausstattung der Halbleiterlaservorrichtung mit einem Linsenmittel und einem Reflexionsmittel als durchaus sinnvoll. Insbesondere sollten ein sehr kurz brennweitiges, als Fast-Axis-Kollimationslinse dienendes Linsenmittel und ein vergleichsweise sehr lang brennweitiges Reflexionsmittel verwendet werden. Dies hat seinen Grund unter anderem auch darin, dass bei kurzbrennweitigen Reflexionsmitteln unter Umständen eine zu kleine Strahltaille in Slow-Axis-Richtung auf der Austrittsfläche resultieren würde. Zwar könnte durch die Defokussierung beziehungsweise Abstandsänderung des Reflexionsmittels eine größere Strahltaille erreicht werden, aber bei einem kurzbrennweitigen Reflexionsmittel würden sehr viele Moden in das Halbleiterlaserelement zurückgekoppelt, da der Abstand der einzelnen Moden in der Fourierebene bei einer sehr kurzen Brennweite sehr klein ist. Daher sollte vorzugsweise eine langbrennweitige reflektierende Fläche des Reflexionsmittels verwendet werden.

Erfindungsgemäß besteht die Möglichkeit, dass das Halbleiterlaserelement als Breitstreifenemitter ausgebildet ist. Es besteht aber ebenso die Möglichkeit, dass das Halbleiterlaserelement als Barren oder als Stack von Breitstreifenemittern ausgebildet ist.

Vorzugsweise ist vorgesehen, dass die der reflektierenden Fläche zugewandte Austrittsfläche des Halbleiterlaserelementes entspiegelt ist, wobei diese Entspiegelung insbesondere durch eine geeignete Beschichtung realisiert werden kann. Durch diese Entspiegelung wird die Rückkopplung aus dem externen Resonator in das Halbleiterlaserelement verstärkt und die Rückkopplung des internen Resonators erheblich verringert. Hierdurch erhöht sich der Einfluss des externen Modulators auf das Modenspektrum.

Gemäß einer Ausführungsform der vorliegenden Erfindung besteht die Möglichkeit, die reflektierende Fläche des Reflexionsmittels als teilreflektierende Fläche auszubilden, so dass es als Auskoppler dient.

Gemäß der vorliegenden Erfindung ist zwischen dem Halbleiterlaserelement und dem Reflexionsmittel ein Umlenkmittel angeordnet, das Teilstrahlen, die unter einem Winkel zur Normalen auf der Austrittsfläche aus dieser austreten, auf das Reflexionsmittel umlenken kann. Hierbei kann das Umlenkmittel insbesondere derart ausgebildet sein, dass Teilstrahlen, die unter entgegengesetzt gleichen Winkeln zur Normalen auf der Austrittsfläche aus dieser austreten, an gleichen Orten auf der reflektierenden Fläche des Reflexionsmittels auftreffen, so dass sie ineinander überführt und auf die Austrittsfläche zurück reflektiert werden können. Eine derartige Ausführungsform mit zusätzlichem Umlenkmittel erspart somit das zweite Reflexionsmittel.

Hierbei ist vorgesehen, dass das Umlenkmittel und das Reflexionsmittel auf der durch die Mittelsenkrechte auf der Austrittsfläche gegebenen Achse angeordnet sind. Auf diese Weise ergibt sich ein achssymmetrischer Aufbau des externen Resonators.

Erfindungsgemäß ist das Umlenkmittel als Prismenelement ausgebildet. Hierbei kann das Prismenelement derart angeordnet sein, dass die Kathetenflächen der Austrittsfläche des Halbleiterelements zugewandt sind. Weiterhin können hierbei durch geeignete Wahl des Winkels zwischen der Hypotenusenfläche und den Kathetenflächen des Prismenelements und/oder durch geeignete Wahl des Abstandes des Umlenkmittels von der Austrittsfläche Teilstrahlen, die unter einem Winkel gegenüber der Normalen auf der Austrittsfläche aus dieser austreten, durch die reflektierende Fläche des Reflexionsmittels ineinander überführt werden. Insbesondere können somit unterschiedliche transversale Moden dadurch ausgewählt werden, dass man Prismenelemente mit unterschiedlichen Winkeln zwischen Hypotenusenfläche und Kathetenfläche und/oder verschiedene Abstände zwischen Umlenkmittel und Austrittsfläche verwendet.

Es besteht die Möglichkeit, dass die reflektierende Fläche des Reflexionsmittels bei der vorgenannten Anordnung mit einem Umlenkmittel teilreflektierend ausgebildet ist, so dass das Reflexionsmittel als Auskoppler dienen kann. Alternativ dazu kann die reflektierende Fläche des Reflexionsmittels bei dieser Anordnung hoch reflektierend ausgebildet sein, wobei die von der reflektierenden Fläche abgewandte Austrittsfläche des Halbleiterlaserelementes teilreflektierend ausgebildet ist und auf diese Weise als Auskoppler dienen kann.

Es besteht erfindungsgemäß die Möglichkeit, dass zwischen dem Halbleiterlaserelement und dem Reflexionsmittel ein wellenlängenselektives Element angeordnet ist, das insbesondere als Etalon ausgeführt ist. Das wellenlängeselektive Element kann dabei zwischen dem Linsenmittel und dem Reflexionsmittel angeordnet sein. Durch ein derartiges wellenlängenselektives Element besteht die Möglichkeit, bestimmte longitudinale Moden, insbesondere eine longitudinale Mode auszuwählen, so dass das ausgesandte Laserlicht eine geringe spektrale Breite aufweist.

Erfindungsgemäß besteht weiterhin die Möglichkeit, dass das Halbleiterlaserelement nur in Teilbereichen, die der räumlichen Ausdehnung einer gewünschten Mode des Laserlichts entsprechen, mit Spannung beaufschlagt bzw. mit Strom zur Erzeugung von Elektronen-Loch-Paaren versorgt wird. Durch diese vergleichsweise einfach durchführbare Maßnahme kann die Bevorzugung gewünschter Moden des Laserlichts weiter optimiert werden.

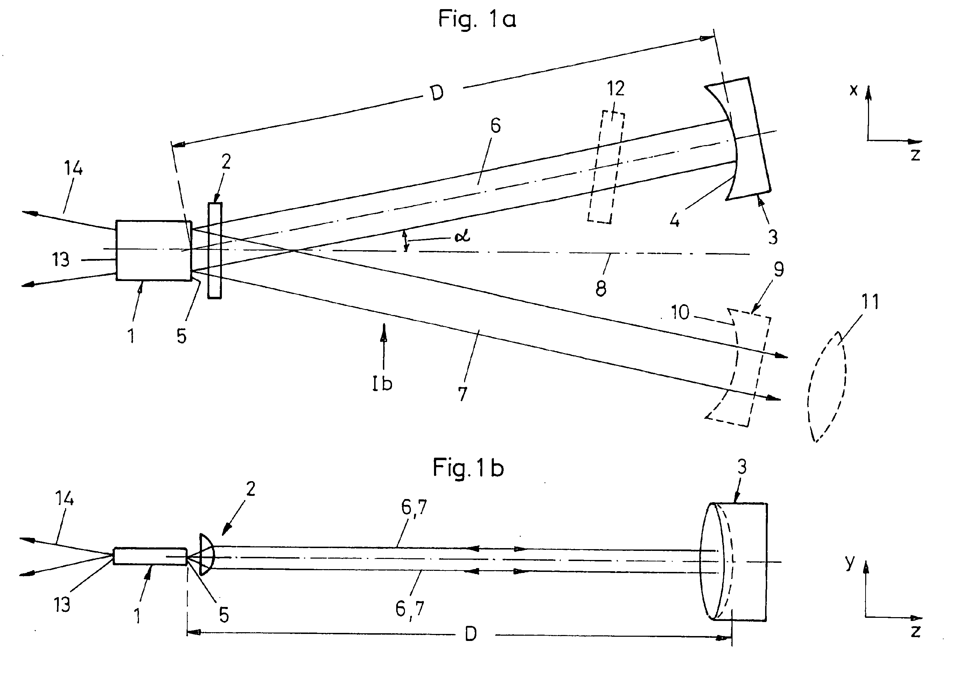

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1a: eine schematische Ansicht einer beispielhaften Halbleiterlaservorrichtung;
- Fig. 1 b: eine Ansicht gemäß dem Pfeil Ib in Fig. 1a;
- Fig. 2a: eine schematische Ansicht einer Ausführungsform einer erfindungsgemäßen Halbleiterlaservorrichtung;
- Fig. 2b: eine Ansicht gemäß dem Pfeil IIb in Fig. 2a.

Aus Fig 1a und Fig. 1b ist eine beispielhaften Halbleiterlaservorrichtung ersichtlich, die ein Halbleiterlaserelement 1, ein insbesondere als Fast-Axis-Kollimationslinse ausgeführtes Linsenmittel 2 sowie mindestens ein als konkaver Spiegel ausgeführtes Reflexionsmittel 3 umfasst. Dabei bildet eine dem Halbleiterlaserelement 1 zugewandte reflektierende konkave Fläche 4 zusammen mit einer dem Reflexionsmittel 3 zugewandten Austrittsfläche 5 des Halbleiterlaserelementes 1 einen externen Resonator.

Das Halbleiterlaserelement 1 ist insbesondere als Halbleiterlaserdiode und dabei insbesondere als Breitstreifenemitter ausgebildet. Bei einem Breitstreifenemitter ist auf der in Fig. 1a und Fig. 1b rechten Seite eine Emissionsfläche vorgesehen, die in X-Richtung (siehe Fig. 1a) eine Ausdehnung von beispielsweise 100 µm aufweist und in Y-Richtung (siehe Fig. 1b) eine Ausdehnung von beispielsweise 1 µm aufweist. Dementsprechend nennt man die X-Richtung bei einem derartigen Breitstreifenemitter die Slow-Axis und die Y-Richtung die Fast-Axis. Ein derartige Breitstreifenemitter weist insbesondere dann, wenn man einzelne transversale Moden betrachtet, in der Fast-Axis und damit in der Y-Richtung eine wesentlich größere Divergenz auf als in der Slow-Axis und damit in der X-Richtung. In den Fig. 1a und Fig. 1b sind diese Größenverhältnisse nicht realistisch dargestellt, sondern zur Verdeutlichung abgeändert.

Es besteht weiterhin die Möglichkeit, dass das Halbleiterlaserelement 1 als Laserdiodenbarren ausgebildet ist, bei dem mehrere der vorgenannten Breitstreifenemitter in X-Richtung beabstandet und miteinander fluchtend angeordnet sind. Es besteht weiterhin die Möglichkeit, dass das Halbleiterlaserelement 1 als Stack derartiger Laserdiodenbarren ausgebildet ist, bei dem mehrere dieser Laserdiodenbarren in Y-Richtung übereinander angeordnet sind.

Es besteht weiterhin die Möglichkeit, die Austrittsfläche 5 für die Laserstrahlung des Halbleiterlaserelementes 1 weitestgehend zu entspiegeln.

Wie aus Fig. 1a und Fig. 1b ersichtlich ist, kann das Linsenmittel 2 als Zylinderlinse ausgebildet sein, deren Zylinderachse sich längs der X-Richtung erstreckt, so dass das Linsenmittel 2 die Divergenz der von dem Halbleiterlaserelement ausgehenden Laserstrahlung in Richtung der Fast-Axis verkleinern oder auch vollständig kollimieren kann. Dies ist in Fig. 1b schematisch verdeutlicht.

Das Linsenmittel 2 kann beispielsweise als plankonvexe Zylinderlinse ausgebildet sein. Insbesondere kann dabei die Zylinderoberfläche als nichtkreisförmige Zylinderoberfläche gestaltet sein. Das Linsenmittel 2 weist vorzugsweise eine große Apertur auf, so dass nur geringe Abbildungsfehler auftreten. Beispielsweise kann der Brechungsindex sehr hoch gewählt werden, beispielsweise zwischen 1,7 und 1,9, insbesondere kann der Brechungsindex n = 1,82 sein. Die Brennweite kann insbesondere sehr klein gewählt werden, beispielsweise kann eine Brennweite f = 1 mm gewählt werden.

Von dem von dem Halbleiterlaserelement 1 ausgehenden Laserlicht ist beispielhaft lediglich in Fig. 1a und Fig. 1b derjenige Anteil in Form von Teilstrahlen 6, 7 abgebildet, der auf eine vergleichsweise starke beispielhaft herausgegriffene Mode des Laserlichtes entfällt. In der Regel breiten sich bei dem vorgenannten als Breitstreifenemittern ausgebildeten Halbleiterlaserelementen 1 die stärksten transversalen Moden unter einem Winkel α von einigen Grad, beispielweise von α = 7°, zur Normalen 8 auf der Austrittsfläche 5 aus. Die Richtung der Normalen 8 entspricht in Fig. 1a und Fig. 1b der Z-Richtung. Der Anteil des Laserlichtes, der einer beispielhaft herausgegriffenen Mode entspricht, die unter einem Winkel α zur Normalen 8 aus der Austrittsfläche 5 austritt, ist in zwei Teilstrahlen 6, 7 aufgespalten, von denen sich der erste Teilstrahl 6 unter einem positiven Winkel α zur Z-Richtung und der zweite Teilstrahl 7 unter einem negativen Winkel α zur Z-Richtung bzw. zur Normalen 8 ausbreitet. Der Teilstrahl 6 verläuft somit in Fig. 1a schräg nach oben und nach rechts und trifft auf die reflektierende konkave Fläche 4 des Reflexionsmittels 3. Der Teilstrahl 7 verläuft in Fig. 1a nach rechts und unten und kann in einer Ausführungsform der vorliegenden Erfindung ungehindert aus der Halbleiterlaservorrichtung austreten.

Bei einer weiteren Ausführungsform besteht die Möglichkeit, im gleichen Abstand, in dem das Reflexionsmittel 3 von der Austrittsfläche 5 angeordnet ist, ein zweites Reflexionsmittel 9 mit einer der Austrittsfläche 5 zugewandten reflektierenden konkaven Fläche 10 vorzusehen. Dieses Reflexionsmittel 9 kann gegebenenfalls teilverspiegelt werden, so dass ein Teil des Laserlichtes durch das Reflexionsmittel 9 hindurchtreten kann. Hinter diesem Reflexionsmittel kann eine Kollimationslinse 11 angeordnet werden. Es besteht durchaus die Möglichkeit, das Reflexionsmittel 9 und die Kollimationslinse 11 in einem Bauteil zusammenzufassen. Das Reflexionsmittel 9 und die Kollimationslinse 11 sind in Fig. 1a (nicht jedoch in Fig. 1b) gestrichelt eingezeichnet.

Es besteht die Möglichkeit, die Krümmung des Reflexionsmittels 3 und gegebenenfalls auch die Krümmung des Reflexionsmittels 10 derart zu wählen, dass die Teilstrahlen 6, 7 im wesentlichen in sich selbst zurück überführt werden, so dass sie auf die Austrittsfläche 5 auftreffen. Hierzu kann der optische Abstand D zwischen der reflektierenden Fläche 4 des Reflexionsmittels 3 bzw. der reflektierenden Fläche 10 des Reflexionsmittels 9 und der Austrittsfläche 5 in Richtung des Teilstrahls 6 bzw. in Richtung des Teilstrahls 7 derart gewählt werden, dass die Brennweite F des durch die konkave reflektierende Fläche 4 bzw. durch die Fläche 10 gebildeten Hohlspiegels dem optischen Abstand D entspricht, so dass im wesentlichen F = D. Bei Ausgestaltung der reflektierenden Fläche 4 als sphärische Fläche kann somit F = R/2 = D sein. Bei unterschiedlicher Krümmung der reflektierenden Fläche 4 in Fast-Axis- und Slow-Axis-Richtung kann der optische Abstand D gemäß der voranstehenden Formel unter Verwendung des Radius in der Slow-Axis-Richtung bestimmt werden.

Weiterhin kann durch geeignete Wahl des Abstandes D bzw. der Brennweite des Reflexionsmittels 3 erreicht werden, dass die Strahltaille der zu einzelnen transversalen Moden gehörenden Teilstrahlen 6, 7 auf der Austrittsfläche 5 der von dem Reflexionsmittel 3 und/oder dem Reflexionsmittel 9 auf die Austrittsfläche 5 zurückreflektierten Teilstrahlen 6, 7 im wesentlichen der Größe der Austrittsfläche 5 des als Breitstreifenemitters ausgebildeten Halbleiterlaserelements 1 entspricht. Die Austrittsfläche 5 dient somit als Apertur, durch die hindurch die zurückreflektierten Teilstrahlen 6, 7 in das Halbleiterlaserelement 1 eintreten können bzw. eingekoppelt werden.

Wie im vorgenannten ausgeführt, besteht die Möglichkeit, die Reflexionsmittel 3, 9 als sphärische Konkavspiegel auszubilden. Bei einer derartigen Ausbildung der Reflexionsmittel 3, 9 sollte das als Fast-Axis-Kollimationslinse dienende Linsenmittel 2 derart dimensioniert werden, dass die Divergenz der einer transversalen Mode entsprechenden Teilstrahlen 6, 7 ausgehend von der Austrittsfläche 5 nach Hindurchtritt durch das Linsenmittel 2 in Y-Richtung eine Divergenz aufweisen, die im wesentlichen der Divergenz in X-Richtung entspricht, so dass beispielsweise im Bereich der Reflexionsmittel 3, 9 vergleichsweise ähnliche Strahldivergenzen und Strahlquerschnitte der Teilstrahlen 6, 7 in Richtung der Slow-Axis und in Richtung der Fast-Axis und mithin etwa in X-Richtung bzw. in Y-Richtung auftreten. Eine derartige Ausführungsform ist in Fig. 1a und Fig. 1b schematisch angedeutet.

Falls ein Linsenmittel 2 verwendet wird, das anders gestaltet ist, insbesondere die Teilstrahlen 6, 7 beinahe vollständig oder vollständig kollimiert, können als Reflexionsmittel 3, 9 konkave Zylinderlinsenspiegel verwendet werden, die eine deutliche Krümmung mit Zylinderachsen in Y-Richtung aufweisen und gar keine oder eine wesentlich weniger deutliche Krümmung mit Zylinderachse in einer dazu senkrechten Richtung aufweisen. Eine derartige Ausführungsform ist in Fig. 1a und Fig. 1b nicht abgebildet.

Durch die im Zusammenhang mit den Ausführungsformen gemäß Fig. 1a und Fig. 1b beschriebene Rückreflektionen einzelner Teilstrahlen 6, 7, die Anteile einer bestimmten ausgewählten Mode sind, wird genau Licht dieser ausgewählten transversalen Mode in das Halbleiterlaserelement 1 zurückgekoppelt, so dass diese ausgewählte transversale Mode mehr oder weniger gut selektiert wird, d. h. dass das Halbleiterlaserelement 1 im wesentlichen nur diese Mode emittiert. Ohne den erfindungsgemäßen externen Resonator aus Reflexionsmittel 3 und gegebenenfalls Reflexionsmittel 10 sowie Austrittsfläche 5 emittiert ein als Breitstreifenemitter ausgebildetes Halbleiterlaserelement 1 Laserlicht mit einer ganzen Reihe von transversalen sowie mit einer ganzen Reihe von longitudinalen Moden. Durch die im vorgenannten beschriebene Rückkopplung einer ausgewählten transversalen Mode in das Halbleiterlaserelement 1 kann mehr oder weniger gut erreicht werden, dass das emittierte Laserlicht im wesentlichen nur diese eine transversale Mode umfasst. Um auch zu erreichen, dass das Laserlicht im wesentlichen aus einer Wellenlänge und damit aus einer longitudinalen Mode besteht, kann in den externen Resonator ein zusätzliches wellenlängenselektives Element 12 eingebracht werden, das beispielsweise als Etalon ausgeführt ist. Dieses wellenlängenselektive Element 12 ist in Fig. 1a (nicht jedoch in Fig. 1b) gestrichelt zwischen dem Reflexionsmittel 3 und dem Linsenmittel 2 angeordnet. Alternativ besteht die Möglichkeit, das wellenlängenselektive Elemente 12 mit dem Reflexionsmittel 3 zu kombinieren, insbesondere in dieses zu integrieren.

Es besteht die Möglichkeit, das Reflexionsmittel 9, das zur besseren Verdeutlichung in Fig. 1b nicht abgebildet ist, teilreflektierend auszugestalten, so dass das Reflexionsmittel 9 gleichzeitig als Auskoppler wirkt. Alternativ dazu kann das Reflexionsmittel 9 auch eine vergleichsweise total reflektierende konkave Fläche 10 aufweisen. In diesem Fall kann die zu der Austrittsfläche 5 parallele, auf der von dem externen Resonator abgewandten Seite des Halbleiterlaserelements 1 angeordnete Austrittsfläche 13 als lediglich teilreflektierende Fläche ausgebildet sein, so dass die Austrittsfläche 13 als Auskoppler dient. In Fig. 1a und Fig. 1b sind zur Verdeutlichung einer derartigen Ausführungsform auf der linken Seite des Halbleiterlaserelementes 1 Strahlen 14 eingezeichnet, die das aus der Austrittsfläche 13 in negativer Z-Richtung austretende Laserlicht schematisch andeuten sollen.

Das Halbleiterlaserelement 1 kann vergleichsweise unstrukturiert sein. Insbesondere müssen keine Führungsmittel vorgesehen sein, die die Ausbreitung einer bestimmten Lasermode bevorzugen.

Weiterhin besteht die Möglichkeit, das Halbleiterlaserelement 1 nur in einem Teilbereich mit Strom für die Erzeugung von Elektronen-Loch-Paaren zu versorgen, wobei dieser Teilbereich im wesentlichen der räumlichen Verteilung der gewünschten anzuregenden Lasermode des Laserlichtes im Inneren des Halbleiterlaserelements 1 entspricht. Demgegenüber werden die übrigen Teilbereiche des Halbleiterlaserelements 1 nicht mit Elektroden versehen, so dass in diesen Bereichen keine Stromzufuhr zur Erzeugung von Elekronen-Loch-Paaren erfolgt. Durch diese gezielte Anordnung der Elektroden kann die Selektion der gewünschten Lasermoden weiter optimiert werden.

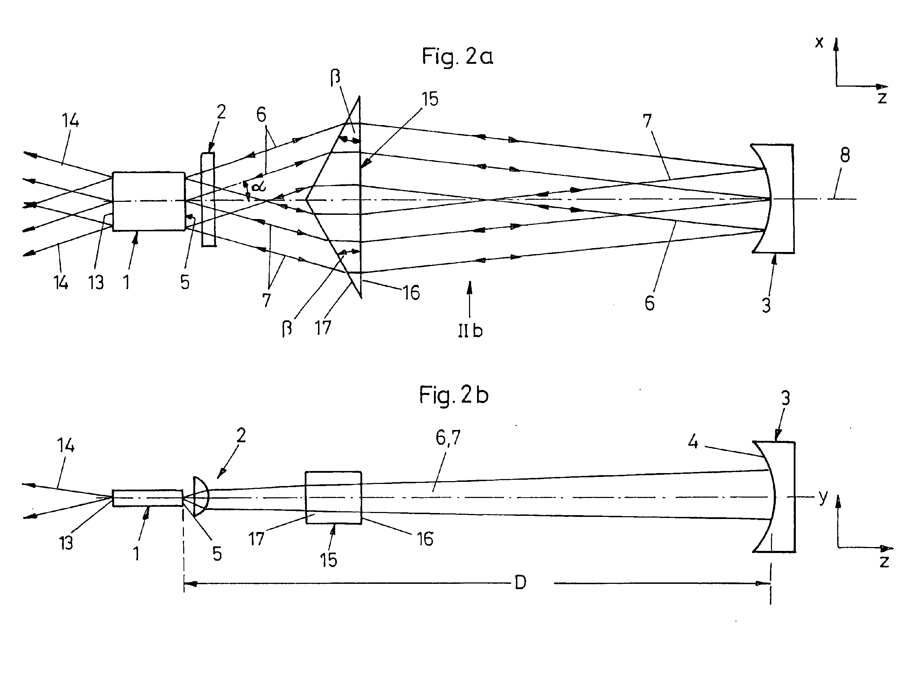

Bei der in Fig. 2a und Fig. 2b abgebildeten Ausführungsform sind gleiche Teile mit gleichen Bezugszeichen versehen wie in Fig. 1a und Fig. 1b. Im Unterschied zu der in Fig. 1a und Fig. 1b abgebildeten Ausführungsform ist bei der in Fig. 2a und Fig. 2b abgebildeten Ausführungsform zwischen dem Linsenmittel 2 und dem Reflexionsmittel 3 ein Prismenelement 15 angeordnet. Weiterhin im Unterschied zur Ausführungsform gemäß Fig. 1a und Fig. 1b ist das Reflexionsmittel 3 rotationssymmetrisch zur Normalen 8 bzw. zur Mittelsenkrechten auf der Austrittsfläche 5 angeordnet. Das Prismenelement 15 dient dazu, die unter einem Winkel ± α aus der Austrittsfläche 5 austretenden Teilstrahlen 6, 7 zur Normalen 8 bzw. zur durch die Normalen 8 gebildeten optischen Achse umzulenken. Zu diesem Zweck weist das Prismenelement 15 eine Hypotenusenfläche 16 auf, die sich in einer X-Y-Ebene erstreckt. Diese Hypotenusenfläche 16 ist auf der dem Reflexionsmittel 3 zugewandten Seite des Prismenelementes 15 angeordnet. Auf der der Austrittsfläche 5 bzw. dem Linsenmittel 2 zugewandten Seite des Prismenelementes 15 sind zwei Kathetenflächen 17 vorgesehen, die jeweils einen Winkel β mit der Hypotenusenfläche 16 einschließen, der entsprechend dem Winkel α gewählt ist. Beispielsweise kann β etwa zweimal so groß sein wie α. Die Kathetenflächen 17 schließen nicht nur einen Winkel β mit der Hypotenusenfläche 16 sondern auch mit der X-Y-Ebene ein, so dass die Teilstrahlen 6, 7 an den Kathetenflächen 17 und daran anschließend an der Hypotenusenfläche 16 (in den schematischen Fig. 2a und Fig. 2b nicht eingezeichnet) gebrochen werden.

Die Krümmung der reflektierenden Fläche 4 des Reflexionsmittels 3 kann erfindungsgemäß vorzugsweise derart gewählt werden, dass die unter gleichem Winkel α nach oben bzw. nach unten und in positiver Z-Richtung aus der Austrittsfläche 5 austretenden Teilstrahlen 6, 7 durch die reflektierende Fläche 4 jeweils in etwa ineinander überführt werden. In Fig. 2a ist dies durch drei herausgegriffene Teilstrahlen 6 verdeutlicht, die an der reflektierenden Fläche 4 in drei Teilstrahlen 7 übergehen.

Auch bei der in Fig. 2a und 2b abgebildeten Ausführungsform kann der optische Abstand D zwischen der reflektierenden Fläche 4 und der Austrittsfläche 5 derart gewählt werden, dass D = R/2 = F der reflektierenden Fläche 4 ist. Weiterhin kann durch geeignete Wahl des Abstandes D bzw. der Brennweite des Reflexionsmittels 3 ebenfalls die Strahltaille der durch die reflektierende Fläche 4 zurückreflektierten Teilstrahlen 6, 7 auf der Austrittsfläche 5 erfindungsgemäß derart gewählt werden, dass sie etwa der durch die Austrittsfläche 5 gegebenen Apertur entspricht.

Bei der Ausführungsform gemäß Fig. 1a und Fig. 1b kann die Selektion einzelner Moden dadurch erfolgen, dass das Reflexionsmittel 3 bzw. die Reflexionsmittel 3, 9 derart gedreht werden, dass von der Austrittsfläche 5 ausgehende und auf die Reflexionsmittel 3, 9 auftreffende Teilstrahlen in sich zurück überführt werden. Durch Verdrehung der reflektierenden Flächen 4, 10 wird somit zwischen Moden ausgewählt, die einen unterschiedlichen Winkel α mit der Normalen 8 einschließen.

Die Modenselektion bei der Ausführungsform gemäß Fig. 2a und Fig. 2b kann durch Veränderung des Winkels β des Prismenelementes 15 und durch Verschiebung des Prismenelements 15 entlang der Z-Richtung erzielt werden. Je nach Größe des Winkels β werden Moden, die einen entsprechenden Winkel α mit der Normalen 8 und damit mit der Z-Richtung einschließen, ausgewählt, deren aus der Austrittsfläche nach oben bzw. nach unten und in positiver Z-Richtung austretende Teilstrahlen durch das Prismenelement 15 im Bereich der reflektierenden Fläche 4 im wesentlichen exakt überlagern.

Erfindungsgemäß sind bei der Ausführungsform gemäß Fig. 2a und Fig. 2b zwei Auskopplungsmöglichkeiten denkbar. Zum einen kann das Reflexionsmittel 3 als nur teilweise reflektierendes Reflexionsmittel ausgebildet sein. Dadurch kann ein Teil des Laserlichts nach rechts in Fig. 2a und somit in Z-Richtung durch das Reflexionsmittel 3 hindurchtreten. Alternativ dazu kann das Reflexionsmittel 3 als im wesentlichen total reflektierendes Reflexionsmittel ausgebildet sein, wohingegen dann die in Fig. 2a linke Austrittsfläche 13 des Halbleiterlaserelements 1 teilreflektierend ausgebildet wird, so dass in negativer Z-Richtung Laserlicht entsprechend den eingezeichneten Strahlen 14 austreten kann. In beiden Fällen sollte die in Fig. 2a rechte Austrittsfläche 5 des Halbleiterlaserelementes 1 vergleichsweise gut entspiegelt sein, so dass die Rückkopplung der Teilstrahlen 6, 7 in das Halbleiterlaserelement 1 möglichst effektiv erfolgen und gleichzeitig die Rückkopplung des internen Resonators verringert wird.

Auch in den externen Resonator gemäß Fig. 2a und Fig. 2b kann ein wellenlängenselektives Element 12 eingebracht werden.

## Patentansprüche

1. Halbleiterlaservorrichtung mit einem externen Resonator, umfassend
- ein Halbleiterlaserelement (1) mit mindestens einer Austrittsfläche (5), aus der Laserlicht austreten kann, das in einer ersten Richtung (Y) eine größere Divergenz aufweist als in einer dazu senkrechten zweiten Richtung;
- mindestens ein beabstandet zu der Austrittsfläche (5) außerhalb des Halbleiterlaserelementes (1) angeordnetes Reflexionsmittel (3, 9) mit einer konkav gekrümmten reflektierenden Fläche (4, 10), die zumindest Teile des aus dem Halbleiterlaserelement (1) durch die Austrittsfläche (5) ausgetretenen Lichts derart in das Halbleiterlaserelement (1) zurückreflektieren kann, dass **dadurch** das Modenspektrum des Halbleiterlaserelementes (1) beeinflusst wird; sowie
- ein zwischen dem Reflexionsmittel (3, 9) und dem Halbleiterlaserelement (1) angeordnetes Linsenmittel (2), das zumindest in der ersten Richtung (Y) die Divergenz des Laserlichtes zumindest teilweise verkleinern kann;
wobei
- der optische Abstand (D) und/oder die Krümmung der reflektierenden Fläche (4, 10) derart gewählt sind, dass die Strahltaille auf der Austrittsfläche (5) von zumindest Teilstrahlen (6, 7) des zu dem Halbleiterlaserelement (1) zurückreflektierten Lichtes im wesentlichen derjenigen Apertur entspricht, die durch die Austrittsfläche (5) gebildet wird, und
- im Inneren des externen Resonators keine zusätzliche Aperturblende angeordnet ist;
**dadurch gekennzeichnet, daß**
- zwischen dem Halbleiterlaserelement (1) und dem Reflexionsmittel (3) ein als Prismenelement (15) ausgebildetes Umlenkmittel angeordnet ist, das Teilstrahlen (6, 7), die unter einem Winkel (α) zur Normalen (8) auf der Austrittsfläche (5) aus dieser austreten, auf das Reflexionsmittel (3) umlenken können, und
- das Umlenkmittel und das Reflexionsmittel (3) auf der durch die Mittelsenkrechte auf der Austrittsfläche (5) gegebenen Achse angeordnet sind.

2. Halbleiterlaservorrichtung nach Anspruch 1, **dadurch gekennzeichnet, dass** die reflektierende Fläche (4, 10) sphärisch gekrümmt ist.

3. Halbleiterlaservorrichtung nach einem der Ansprüche 1 oder 2, **dadurch gekennzeichnet, dass** die reflektierende Fläche (4, 10) in der ersten Richtung (Y) und in der dazu senkrechten zweiten Richtung eine im wesentlichen gleich große Krümmung aufweist.

4. Halbleiterlaservorrichtung nach einem der Ansprüche 1 bis 3 **dadurch gekennzeichnet, dass** der optische Abstand (D) zwischen der reflektierenden Fläche (4, 10) und der Austrittsfläche (5) des Halbleiterlaserelementes (1) im wesentlichen gleich der Brennweite (F) der reflektierenden Fläche (4, 10) hinsichtlich mindestens einer der Richtungen (Y) ist.

5. Halbleiterlaservorrichtung nach einem der Ansprüche 1 bis 4, **dadurch gekennzeichnet, dass** die Brennweite des Linsenmittels (2) sehr klein ist, beispielsweise etwa 1 mm beträgt.

6. Halbleiterlaservorrichtung nach einem der Ansprüche 1 bis 5, **dadurch gekennzeichnet, dass** die dem Reflexionsmittel (3, 9) zugewandte Austrittsfläche (5) des Halbleiterlaserelements eine Breite von mehr als 500 µm, insbesondere mehr als 1 mm aufweist.

7. Halbleiterlaservorrichtung nach einem der Ansprüche 5 oder 6, **dadurch gekennzeichnet, dass** die reflektierende Fläche (4, 10) oder mindestens eine der reflektierenden Flächen (4, 10) als wellenlängenselektives Element, insbesondere als Gitter ausgebildet ist.

8. Halbleiterlaservorrichtung nach einem der Ansprüche 2 bis 7, **dadurch gekennzeichnet, dass** das Halbleiterlaserelement (1) als Breitstreifenemitter ausgebildet ist.

9. Halbleiterlaservorrichtung nach Anspruch 8, **dadurch gekennzeichnet, dass** das Halbleiterlaserelement (1) als Barren oder als Stack von Breitstreifenemittern ausgebildet ist.

10. Halbleiterlaservorrichtung nach einem der Ansprüche 1 bis 9, **dadurch gekennzeichnet, dass** die der reflektierenden Fläche (4, 10) zugewandte Austrittsfläche (5) des Halbleiterlaserelements (1) entspiegelt ist.

11. Halbleiterlaservorrichtung nach Anspruch 1, **dadurch gekennzeichnet, dass** das Prismenelement (15) derart angeordnet ist, dass die Kathetenflächen (17) der Austrittsfläche (5) des Halbleiterlaserelements zugewandt sind.

12. Halbleiterlaservorrichtung nach Anspruch 1 oder 2, **dadurch gekennzeichnet, dass** durch geeignete Wahl des Winkels (β) zwischen der Hypotenusenfläche (16) und den Kathetenflächen (17) des Prismenelementes (15) und/oder durch geeignete Wahl der Position des Prismenelementes (15) zwischen Austrittsfläche (5) und reflektierender Fläche (4) Teilstrahlen (6, 7), die unter einem Winkel (± α) gegenüber der Normalen (8) auf der Austrittsfläche (5) aus dieser austreten, durch die reflektierende Fläche (4) des Reflexionsmittels (3) ineinander überführt werden können.

13. Halbleiterlaservorrichtung nach einem der Ansprüche 1,11 oder 12, **dadurch gekennzeichnet, dass** die reflektierende Fläche (4) des Reflexionsmittels (3) teilreflektierend ausgebildet ist, so dass das Reflexionsmittel (3) als Auskoppler dienen kann.

14. Halbleiterlaservorrichtung nach einem der Ansprüche 1 oder 11-13, **dadurch gekennzeichnet, dass** die reflektierende Fläche (4) des Reflexionsmittels (3) hoch reflektierend ausgebildet ist, wobei die von der reflektierenden Fläche (4) abgewandte Austrittsfläche (13) des Halbleiterlaserelementes (1) teilreflektierend ausgebildet ist und auf diese Weise als Auskoppler dienen kann.

15. Halbleiterlaservorrichtung nach einem der Ansprüche 1 bis 14, **dadurch gekennzeichnet, dass** zwischen dem Halbleiterlaserelement (1) und dem Reflexionsmittel (3, 9) ein wellenlängenselektives Element (12) angeordnet ist, dass insbesondere als Etalon ausgeführt ist.

16. Halbleiterlaservorrichtung nach einem der Ansprüche 1 bis 15, **dadurch gekennzeichnet, dass** das Linsenmittel (2) als Zylinderlinse ausgebildet ist, deren Zylinderachse sich im wesentlichen in der zweiten, zu der ersten Richtung (Y) senkrechten Richtung erstreckt.

17. Halbleiterlaservorrichtung nach einem der Ansprüche 1 bis 16, **dadurch gekennzeichnet, dass** das Linsenmittel (2) derart ausgebildet ist, dass das aus der Austrittsfläche (5) ausgetretene Laserlicht nach Durchgang durch das Linsenmittel (2) in der ersten Richtung (Y) eine etwa gleich große Divergenz aufweist wie in der dazu senkrechten zweiten Richtung.

18. Halbleiterlaservorrichtung nach einem der Ansprüche 1 bis 17, **dadurch gekennzeichnet, dass** das Halbleiterlaserelement (1) nur in Teilbereichen, die der räumlichen Ausdehnung einer gewünschten Mode des Laserlichts entsprechen, mit Spannung beaufschlagt bzw. mit Strom zur Erzeugung von Elektronen-Loch-Paaren versorgt wird.

## Claims

1. Semiconductor laser device with an external resonator, comprising
- a semiconductor laser element (1) having at least one exit surface (5) from which laser light can emerge which has a greater divergence in a first direction (Y) than in a second direction perpendicular thereto;
- at least one reflection means (3, 9) arranged at a distance from the exit surface (5) outside the semiconductor laser element (1) and having a concavely curved reflective surface (4, 10) which can reflect at least parts of the light that has emerged from the semiconductor laser element (1) through the exit surface (5) back into the semiconductor laser element (1) in such a way that the mode spectrum of the semiconductor laser element (1) is thereby influenced; and
- a lens means (2) arranged between the reflection means (3, 9) and the semiconductor laser element (1), which lens means can at least partially reduce the divergence of the laser light at least in the first direction (Y);
wherein
- the optical distance (D) and/or the curvature of the reflective surface (4, 10) are chosen in such a way that the beam waist on the exit surface (5) of at least partial beams (6, 7) of light reflected back to the semiconductor laser element (1) substantially corresponds to that aperture which is formed by the exit surface (5), and
- no additional aperture diaphragm is arranged in the interior of the external resonator;
**characterized in that**
- a deflection means embodied as a prism element (15) is arranged between the semiconductor laser element (1) and the reflection means (3), which deflection means can deflect partial beams (6, 7) which emerge from the exit surface (5) at an angle (α) with respect to the normal (8) to said exit surface onto the reflection means (3), and
- the deflection means and the reflection means (3) are arranged on the axis given by the mid-perpendicular to the exit surface (5).

2. Semiconductor laser device according to Claim 1, **characterized in that** the reflective surface (4, 10) is spherically curved.

3. Semiconductor laser device according to either of Claims 1 and 2, **characterized in that** the reflective surface (4, 10) has a curvature of substantially identical magnitude in the first direction (Y) and in the second direction perpendicular thereto.

4. Semiconductor laser device according to any of Claims 1 to 3, **characterized in that** the optical distance (D) between the reflective surface (4, 10) and the exit surface (5) of the semiconductor laser element
(1) is substantially equal to the focal length (F) of the reflective surface (4, 10) with regard to at least one of the directions (Y).

5. Semiconductor laser device according to any of Claims 1 to 4, **characterized in that** the focal length of the lens means (2) is very small, for example amounting to approximately 1 mm.

6. Semiconductor laser device according to any of Claims 1 to 5, **characterized in that** the exit surface (5) of the semiconductor laser element which faces the reflection means (3, 9) has a width of more than 500 µm, in particular more than 1 mm.

7. Semiconductor laser device according to either of Claims 5 and 6, **characterized in that** the reflective surface (4, 10) or at least one of the reflective surfaces (4, 10) is embodied as a wavelength-selective element, in particular as a grating.

8. Semiconductor laser device according to any of Claims 2 to 7, **characterized in that** the semiconductor laser element (1) is embodied as a broad stripe emitter.

9. Semiconductor laser device according to Claim 8, **characterized in that** the semiconductor laser element (1) is embodied as a bar or as a stack of broad stripe emitters.

10. Semiconductor laser device according to any of Claims 1 to 9, **characterized in that** the exit surface (5) of the semiconductor laser element (1) which faces the reflective surface (4, 10) is antireflection-coated.

11. Semiconductor laser device according to Claim 1, **characterized in that** the prism element (15) is arranged in such a way that the cathetus surfaces (17) face the exit surface (5) of the semiconductor laser element.

12. Semiconductor laser device according to Claim 1 or 2, **characterized in that** by a suitable choice of the angle (β) between the hypotenuse surface (16) and the cathetus surfaces (17) of the prism element (15) and/or by a suitable choice of the position of the prism element (15) between exit surface (5) and reflective surface (4), partial beams (6, 7) which emerge from the exit surface (5) at an angle (± α) relative to the normal (8) to said exit surface can be merged into one another by the reflective surface (4) of the reflection means (3).

13. Semiconductor laser device according to any of Claims 1, 11 or 12, **characterized in that** the reflective surface (4) of the reflection means (3) is embodied in partly reflective fashion, such that the reflection means (3) can serve as a coupling-out unit.

14. Semiconductor laser device according to any of Claims 1 or 11-13, **characterized in that** the reflective surface (4) of the reflection means (3) is embodied in highly reflective fashion, wherein the exit surface (13) of the semiconductor laser element (1) which is remote from the reflective surface (4) is embodied in partly reflective fashion and in this way can serve as a coupling-out unit.

15. Semiconductor laser device according to any of Claims 1 to 14, **characterized in that** a wavelength-selective element (12) is arranged between the semiconductor laser element (1) and the reflection means (3, 9), said wavelength-selective element being embodied in particular as an etalon.

16. Semiconductor laser device according to any of Claims 1 to 15, **characterized in that** the lens means (2) is embodied as a cylindrical lens whose cylinder axis extends substantially in the second direction perpendicular to the first direction (Y).

17. Semiconductor laser device according to any of Claims 1 to 16, **characterized in that** the lens means (2) is embodied in such a way that the laser light that has emerged from the exit surface (5), after passing through the lens means (2), has in the first direction (Y) a divergence approximately equal in magnitude to that in the second direction perpendicular thereto.

18. Semiconductor laser device according to any of Claims 1 to 17, **characterized in that** the semiconductor laser element (1) has voltage applied to it or is supplied with current for the generation of the electron-hole pairs only in partial regions which correspond to the spatial extent of a desired mode of the laser light.

## Revendications

1. Dispositif laser à semi-conducteur doté d'un résonateur externe et comprenant :
- un élément (1) de laser à semi-conducteur qui présente au moins une surface de sortie (5) par laquelle la lumière laser peut sortir et qui présente dans une première direction (Y) une divergence plus grande que dans une deuxième direction perpendiculaire à la première,
- au moins un moyen réfléchissant (3, 9) disposé à distance de la surface de sortie (5) et à l'extérieur de l'élément (1) de laser à semi-conducteur, et qui présente une surface réfléchissante (4, 10) à courbure concave capable de réfléchir au moins une partie de la lumière qui est sortie de l'élément (1) de laser à semi-conducteur par la surface de sortie (5) de l'élément (1) de laser à semi-conducteur de manière à agir sur le spectre modal de l'élément (1) de laser à semi-conducteur, ainsi que
- un moyen à lentille (2) disposé entre le moyen réfléchissant (3, 9) et l'élément (1) de laser à semi-conducteur et capable de diminuer au moins en partie la divergence de la lumière laser au moins dans la première direction (Y),
- la distance optique (D) et/ou la courbure de la surface réfléchissante (4, 10) étant sélectionnées de telle sorte que sur la surface de sortie (5), la taille d'au moins un des faisceaux partiels (6, 7) de la lumière réfléchie en direction de l'élément (1) de laser à semi-conducteur corresponde essentiellement à l'ouverture formée par la surface de sortie (5),
- aucun obturateur d'ouverture supplémentaire n'étant disposé à l'intérieur du résonateur externe,
**caractérisé en ce que**
- entre l'élément (1) de laser à semi-conducteur et le moyen réfléchissant (3) est disposé un moyen de déviation configuré comme élément prismatique (15) qui permet de dévier sur le moyen réfléchissant (3) des rayons partiels (6, 7) qui sortent de la surface de sortie (5) sous un angle (α) par rapport à la normale (8) de la surface de sortie et
- **en ce que** le moyen de déviation et le moyen réfléchissant (3) sont disposés sur l'axe défini par la perpendiculaire au milieu de la surface de sortie (5).

2. Dispositif laser à semi-conducteur selon la revendication 1, **caractérisé en ce que** la surface réfléchissante (4, 10) a une courbure sphérique.

3. Dispositif laser à semi-conducteur selon l'une des revendications 1 ou 2, **caractérisé en ce que** la surface réfléchissante (4, 10) présente des courbures essentiellement identiques dans la première direction (Y) et dans la deuxième direction perpendiculaire à la première.

4. Dispositif laser à semi-conducteur selon l'une des revendications 1 à 3, **caractérisé en ce que** la distance optique (D) entre la surface réfléchissante (4, 10) et la surface de sortie (5) de l'élément (1) de laser à semi-conducteur est essentiellement égale à la distance focale (F) de la surface réfléchissante (4, 10) dans au moins une des directions (Y).

5. Dispositif laser à semi-conducteur selon l'une des revendications 1 à 4, **caractérisé en ce que** la distance focale du moyen de lentille (2) est très petite et vaut par exemple environ 1 mm.

6. Dispositif laser à semi-conducteur selon l'une des revendications 1 à 5, **caractérisé en ce que** la surface de sortie (5) de l'élément de laser à semi-conducteur tournée vers le moyen réfléchissant (3, 9) présente une largeur supérieure à 500 µm et en particulier supérieure à 1 mm.

7. Dispositif laser à semi-conducteur selon l'une des revendications 5 ou 6, **caractérisé en ce que** la surface réfléchissante (4, 10) ou au moins l'une des surfaces réfléchissantes (4, 10) est configurée comme élément sélectif vis-à-vis des longueurs d'onde et en particulier sous la forme d'une grille.

8. Dispositif laser à semi-conducteur selon l'une des revendications 2 à 7, **caractérisé en ce que** l'élément (1) de laser à semi-conducteur est configuré comme émetteur à bandes de largeur.

9. Dispositif laser à semi-conducteur selon la revendication 8, **caractérisé en ce que** l'élément (1) de laser à semi-conducteur est configuré comme barreaux ou comme empilement d'émetteurs de bandes de largeur.

10. Dispositif laser à semi-conducteur selon l'une des revendications 1 à 9, **caractérisé en ce que** la surface de sortie (5) de l'élément (1) de laser à semi-conducteur tournée vers la surface réfléchissante (4, 10) est rendue non réfléchissante.

11. Dispositif laser à semi-conducteur selon la revendication 1, **caractérisé en ce que** l'élément prismatique (15) est disposé de telle sorte que la surface de cathète (17) est tournée vers la surface de sortie (5) de l'élément laser à semi-conducteur.

12. Dispositif laser à semi-conducteur selon les revendications 1 ou 2, **caractérisé en ce que** par un choix approprié de l'angle (β) entre la surface d'hypoténuse (16) et la surface de cathète (17) de l'élément prismatique (15) et/ou par un choix sélectionné de la position de l'élément prismatique (15) entre la surface de sortie (5) et la surface réfléchissante (4), des rayons partiels (6, 7) qui sortent par la surface de sortie (5) sous un angle (± α) par rapport à la normale (8) à la surface de sortie peuvent être convertis l'un en l'autre par la surface réfléchissante (4) du moyen réfléchissant (3).

13. Dispositif laser à semi-conducteur selon l'une des revendications 1, 11 ou 12, **caractérisé en ce que** la surface réfléchissante (4) du moyen réfléchissant (3) est partiellement réfléchissante de telle sorte que le moyen réfléchissant (3) puisse servir de découpleur.

14. Dispositif laser à semi-conducteur selon l'une des revendications 1 ou 11 à 13, **caractérisé en ce que** la surface réfléchissante (4) du moyen réfléchissant (3) est fortement réfléchissante, la surface de sortie (13) de l'élément (1) de laser à semi-conducteur non tournée vers la surface réfléchissante (4) étant partiellement réfléchissante et pouvant ainsi servir de découpleur.

15. Dispositif laser à semi-conducteur selon l'une des revendications 1 à 14, **caractérisé en ce qu'**un élément (12) sélectif vis-à-vis des longueurs d'onde, en particulier configuré comme étalon, est disposé entre l'élément (1) de laser à semi-conducteur et le moyen réfléchissant (3, 9).

16. Dispositif laser à semi-conducteur selon l'une des revendications 1 à 15, **caractérisé en ce que** le moyen de lentille (2) est configuré comme lentille cylindrique dont l'axe du cylindre s'étend essentiellement dans la deuxième direction, perpendiculaire à la première direction (Y).

17. Dispositif laser à semi-conducteur selon l'une des revendications 1 à 16, **caractérisé en ce que** le moyen de lentille (2) est configuré de telle sorte qu'après avoir traversé le moyen de lentille (2) dans la première direction (Y), la lumière laser qui sort par la surface de sortie (5) présente une divergence sensiblement aussi grande que dans la deuxième direction perpendiculaire à la première.

18. Dispositif laser à semi-conducteur selon l'une des revendications 1 à 17, **caractérisé en ce que** l'élément (1) de laser à semi-conducteur n'est alimenté en tension ou en courant pour former des paires électron-trou que dans ses parties qui correspondent à l'extension spatiale d'un mode souhaité de la lumière laser.
